Europäisches Patentamt

European Patent Office

Office européen des brevets

(19)

(11) Numéro de publication: **0 328 617 B1**

(12) **FASCICULE DE BREVET EUROPEEN**

(45) Date de publication de fascicule du brevet: **18.11.93**   (51) Int. Cl.5: **H03D 3/00**, G01S 1/56

(21) Numéro de dépôt: **88907712.9**

(22) Date de dépôt: **30.08.88**

(86) Numéro de dépôt internationale :
**PCT/FR88/00428**

(87) Numéro de publication internationale :
**WO 89/02188 (09.03.89 89/06)**

(54) **DISPOSITIF DE DEMODULATION DE PHASE ET SON APPLICATION A UN SYSTEME D'ATTERRISSAGE DE TYPE MLS.**

(30) Priorité: **04.09.87 FR 8712330**

(43) Date de publication de la demande:
**23.08.89 Bulletin 89/34**

(45) Mention de la délivrance du brevet:
**18.11.93 Bulletin 93/46**

(84) Etats contractants désignés:
**DE GB IT NL**

(56) Documents cités:
**WO-A-86/00186**
**DE-A- 2 158 984**
**US-A- 3 938 052**
**US-A- 4 042 884**

(73) Titulaire: **THOMSON-CSF**
**51, Esplanade du Général de Gaulle**
**F-92800 Puteaux(FR)**

(72) Inventeur: **GROUSSEAU, Alain**
**24 ter, rue du Plateau-du-Moulin**
**F-78700 Conflans-Ste-Honorine(FR)**
Inventeur: **BRAULT, Daniel**
**116, rue Alfred-de-Musset**
**F-95370 Montigny-les-Cormeilles(FR)**

(74) Mandataire: **Benoit, Monique et al**
**THOMSON-CSF**
**SCPI**
**B.P. 329**
**50, rue Jean-Pierre Timbaud**
**F-92402 Courbevoie Cédex (FR)**

EP 0 328 617 B1

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

**Description**

La présente invention a pour objet un dispositif de démodulation de phase du type DPSK (initiales de l'expression anglaise Differential Phase Shift Keying) possédant les caractéristiques énumérées à la Revendication 1.

Elle a également pour objet l'application de ce dispositif à un système d'aide à l'atterrissage de type MLS (initiales de l'expression anglaise Microwave Landing System).

La transmission d'information utilise de plus en plus la modulation de la phase d'une onde porteuse radioélectrique. Le signal s'écrit, dans le général :

$$s\,(t) = A\,.\,Sin[\omega_0 t + \theta\,(t)] \qquad (1)$$

où A est l'amplitude de ce signal, $\omega_0$ la pulsation correspondant à la fréquence porteuse et $\theta(t)$, le signal de modulation en fonction du temps. Dans le cas d'une modulation biphase (BPSK), le signal $\theta(t)$ sera alternativement égal à 0 ou à $\pi$ selon que le bit envoyé sera 0 ou 1 ; ce type de modulation est généralisable en modulation multiphase (MPSK).

A la réception, il est donc nécessaire de démoduler (ou "décoder") le signal reçu pour extraire le signal utile $\theta(t)$ dans le signal composé s(t). Le démodulateur selon l'invention vise à réaliser une telle démodulation dans le cas où ne sont connues exactement ni la fréquence, ni la phase de l'onde porteuse.

Pour résoudre ce problème, différentes solutions sont connues, et notamment décrites dans l'ouvrage de Spilker Junior, intitulé "Digital Communications by Satellite" publié par Prentice Hall. L'une de ces solutions, décrite page 304 et appelée boucle de Costa, utilise un oscillateur commandé en tension (ou VCO pour Voltage Controled Oscillator dans la littérature anglo-saxonne) et une boucle d'asservissement. Une autre solution, décrite page 302, utilise également un oscillateur du type VCO et des boucles d'asservissement ; elle comporte de plus des dispositifs doubleurs de fréquence. Ces dispositifs ont pour principal inconvénient leur complexité et le fait qu'ils nécessitent un oscillateur du type VCO, ce qui les rend onéreux. Une autre dispositif doté d'un VCO est décrit dans US-A-4 042 884

La présente invention a pour objet un démodulateur de phase qui soit plus simple et, notamment, qui ne nécessite pas d'oscillateur du type VCO, et qui possède les caracteristiques énumérées à la revendication 1

A cet effet, il utilise un oscillateur alimentant un modulateur de phase. Le signal de sortie du modulateur de phase est mélangé au signal démodulé et il est appliqué à une boucle dont le signal de sortie

:
- commande le modulateur ;
- constitue le signal de sortie du démodulateur.

Le dispositif de démodulation de phase comporte :
- des moyens (2) de modulation de la phase du premier signal ($S_1$) de fréquence ($\omega_1$) fixe et voisine de celle ($\omega_0$) d'un deuxième signal (s(t)), à démoduler ;
- des moyens (5 ; 51) assurant le mélange des deux signaux précédents ;
- des moyens (3) formant filtre de boucle, recevant le signal ($S_5$ ; $S_{51}$) issu des moyens mélangeurs, le signal de sortie de ces moyens (3) filtre de boucle assurant la commande des moyens (2) de modulation :
- des moyens (4) de traitement assurant un filtrage, recevant le signal de sortie des moyens filtre de boucle et formant le signal de sortie du dispositif.

D'autres particularités et résultats de l'invention ressortiront de la description suivante, donnée à titre d'exemple non limitatif et illustrée par les dessins annexés, qui représentent :
- la figure 1, le schéma de principe d'un dispositif de démodulation de phase ;
- la figure 2, un mode de réalisation de la figure précédente ;
- les figures 3, 4 et 4b, des schémas explicatifs du fonctionnement du dispositif selon l'invention.

Sur ces différentes figures, les mêmes références se rapportent aux mêmes éléments.

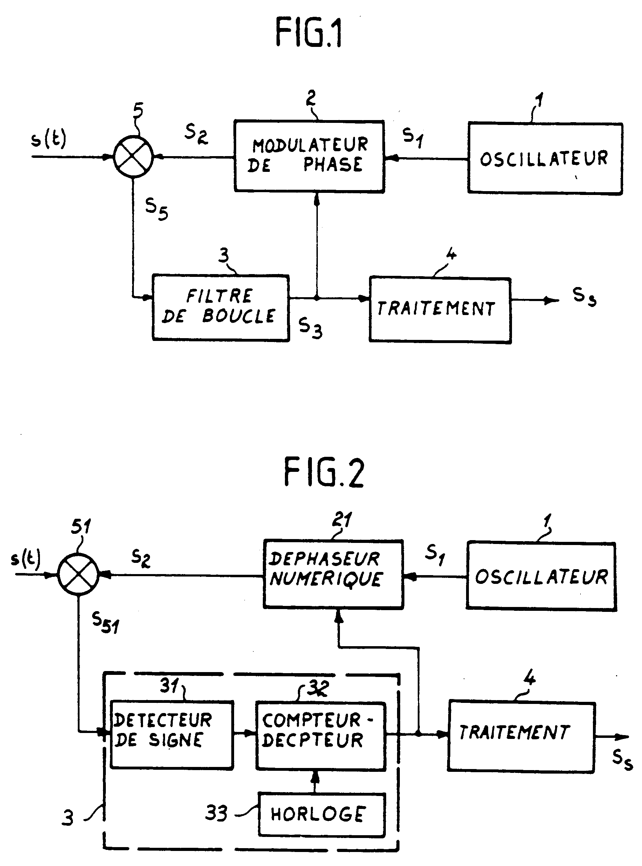

la figure 1 représente le schéma de principe d'un dispositif de démodulation de phase.

Il comporte un oscillateur 1, fournissant un signal $S_1$ à fréquence constante et stable, qui s'écrit :

$$S_1 = A_1\,.\,Sin\,\omega_1\,t \qquad (2)$$

où $A_1$ est son amplitude et $\omega_1$ sa pulsation.

Ce signal est dirigé vers un modulateur de phase 2. Le signal de sort $S_2$ du modulateur 2 s'écrit :

$$S_2 = A_2\,.\,Sin\,[\omega_1 t + \phi\,(t)] \qquad (3)$$

où $A_2$ est l'amplitude du signal et $\phi(t)$ est la modulation de phase réalisée par le modulateur 2.

Le signal $S_2$ est ensuite mélangé au signal d'entrée à démoduler s(t) donné par l'expression (1). Le signal de sortie du mélangeur 5 s'écrit :

$$S_5 = K.A.A_2\,.\,Sin\,[\omega_0 t + \theta\,(t)]\,.\,Sin\,[\omega_1 t + \phi\,(t)]$$

Si $\omega_1$ est voisin de $\omega_0$ et en posant :

$$\omega_o - \omega_1 = \Delta\omega \, ,$$

on a :

$$S_5 = K.A.A_2 .\{ \cos [\Delta\omega .t + \theta (t)- \phi (t)] - \cos [ (2 \omega_o - \Delta\omega)t + \theta (t) + \phi (t)] \}$$

Le signal $S_5$ est, après filtrage passe bas effectué dans un filtre de boucle 3, transformé en un signal $S_3$ qui s'écrit :

$$S_3 = k.A.A_2 . \cos [ \Delta\omega .t + \theta (t) - \phi (t)] \qquad (4)$$

Le signal $S_3$, d'une part assure la commande du modulateur 2, formant ainsi une boucle, et d'autre part constitue, après passage dans un circuit 4 de traitement classique, opérant notamment un filtrage, le signal de sortie $S_s$ du dispositif.

En effet, la boucle de phase, lorsqu'elle fonctionne dans sa plage normale de fonctionnement, tend à annuler le signal $S_3$ appliqué au modulateur 2, signal qui joue le rôle d'un signal d'erreur. Cela s'écrit :

$$k. A.A_2 . \cos [\Delta\omega . t + \theta (t) - \phi (t)] \rightarrow O$$

c'est-à-dire :

$$\Delta\omega .t + \theta (t) - \phi (t) = \frac{\pi}{2} + \eta \pi$$

ou :

$$\phi (t) = \phi_o + \Delta\omega.t + \theta (t) \qquad (5)$$

avec :
- $\phi_o$ : constante ;
- $\Delta\omega$ correspondant à l'écart à l'écart entre la fréquence du signal s(t) reçu et le signal $S_1$ fournie par l'oscillateur local ;
- $\theta(t)$ : signal de modulation recherché.

Il apparaît que le filtrage réalisé par le circuit 4 permet de s'affranchir du signal continu $\phi_o$ et du signal basse fréquence $\Delta\omega t$ pour ne conserver que le signal $\theta(t)$ recherché, sous réserve que la variation de phase correspondant à $\Delta\omega$ reste lente par rapport à la variation du à la modulation $\theta(t)$

Cela est donc, réalisé sans reconstitution de la porteuse (sin$\omega_o$t) du signal émis.

La figure 2 représente un mode de réalisation selon l'invention du schéma de la figure 1.

Sur cette figure, on retrouve l'oscillateur local 1, qui fournit le signal $S_1$ à fréquence fixe. Ce signal $S_1$ voit sa phase modulée par un déphaseur numérique 21. Le signal de sortie $S_2$ du déphaseur 21 est dirigé vers un mélangeur qui, dans ce mode de réalisation, est un dispositif 51 de comparaison de phase où sa phase est comparée à celle du signal d'entrée s(t) pour délivrer un signal $S_{51}$. Ce

dernier est traité dans le filtre de boucle 3, constitué ici par un détecteur de signe 31, ayant pour fonction de détecter le signe positif ou négatif du signal $S_{51}$, et d'un compteur-décompteur 32, comptant ou décomptant au rythme d'une horloge 33 en fonction du signe du signal $S_{51}$. Le détecteur de signe 31, est réalisé par exemple à l'aide d'un comparateur, comparant le signal incident $S_{51}$, au niveau zéro volt. L'horloge 33 est une horloge rapide par rapport à la fréquence du signal de modulation, par exemple 100 fois plus élevée.

Le signal de sortie de l'ensemble 3, noté $S_3$, d'une part commande le déphaseur numérique 21 et d'autre part est adressé au circuit 4 de traitement (filtrage) pour constituer le signal de sortie $S_s$ du dispositif.

Le fonctionnement de ce circuit s'effectue selon ce qui a été expliqué plus haut, c'est-à-dire que la boucle de phase tend à annuler le signal qui y circule et, ce, pour chacun des échantillons successifs. En d'autres termes, le déphaseur numérique 21 suit l'évolution de la phase différentielle entre l'oscillateur local 1 et le signal s(t) à démoduler, quelle que soit la vitesse de variation de cette phase à condition qu'elle reste faible devant la fréquence de l'horloge 33. En sortie du compteur-décompteur 32, on a donc un signal tel que donné par l'expression (5) ci-dessus, c'est-à-dire :

$$\phi (t) = \phi_o + \Delta\omega\bullet t + \theta (t)$$

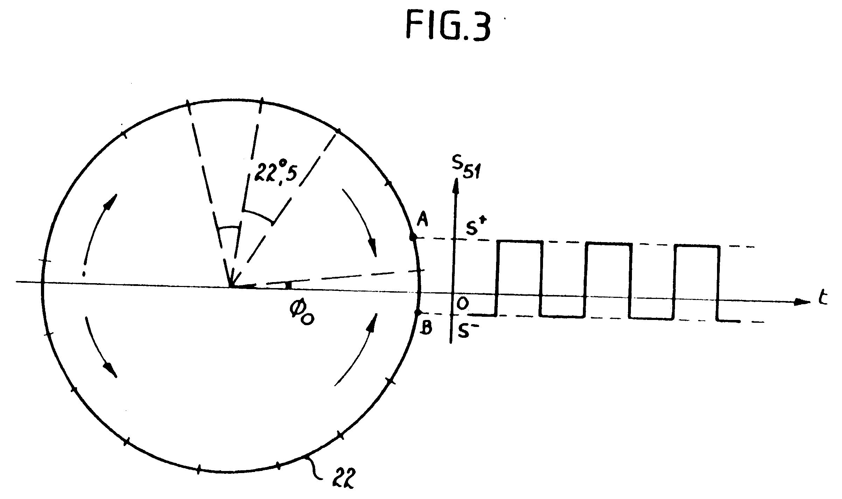

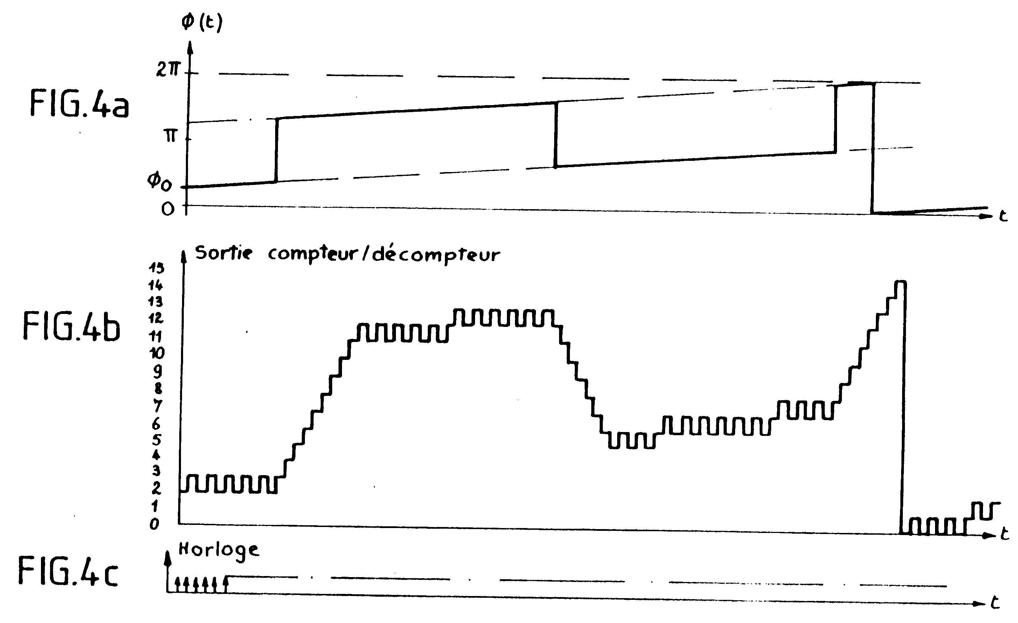

En pratique, le déphaseur 21 étant quantifié et le compteur-décompteur 32 n'étant jamais bloqué, le système ne possède pas d'état stable. Son fonctionnement est illustré ci-après figures 3 et 4.

La figure 3 est un schéma illustrant le fonctionnement du dispositif de la figure précédente dans le cas où $\Delta\omega.t = 0$ et où il n'y a pas de saut de phase dû à la modulation ($\theta = 0$), c'est-à-dire que $\phi(t) = \phi_o$.

On a représenté sur un cercle 22 les déphasages qu'est susceptible d'imposer le déphaseur 21 au signal $S_1$ ; ils sont par exemple au pas de 22,5°. On a également représenté le signal de sortie du comparateur de phase 51 en l'absence de saut de phase dû à la modulation : c'est alors une tension $S_{51}$ variant entre une valeur positive ($S^+$) et une valeur négative ($S^-$) qui ne sont pas obligatoirement égales en valeur absolue. On a représenté par A et B les points correspondants du cercle des phases 22. Les points A et B sont situés de part et d'autre de la valeur $\phi_o$. Le système oscille donc entre ces deux valeurs de phase.

Lorsque le signal de modulation $\theta(t)$ est égal à $\pi$, la valeur de $\phi(t)$ passe à un point du cercle 22 diamétralement opposé à A ou B pour revenir, (flèches sur la figure), au fur et à mesure des tops de l'horloge 33 en A ou B (huit tops dans l'exemple de la figure), c'est le signe du signal ($S_{51}$) issu du détecteur de phase qui est pris en compte pour, selon le cas, déclencher une incrémentation ou une décrémentation de la phase du signal $S_1$.

Il apparaît ainsi que les points A et B constituent la position de repos de l'asservissement entre deux sauts de phase, avec recherche permanente d'équilibre.

De la sorte, on a constitué un système convergent, sans position stable : en effet, dans le cas contraire, les valeurs de $\phi(t)$ fournies par le système le seraient à $n.\pi$ près, ce qui empêche la démodulation d'une modulation de phase $0-\pi$.

Les figures 4, a à c, illustrent le fonctionnement du dispositif de la figure 2 dans le cas général où $\phi(t) = \phi_o + \Delta\omega.t + \theta(t)$.

Le diagramme 4a représente, en fonction du temps, la variation entre 0 et $2\pi$ de la phase $\phi(t)$ résultant de la superposition d'une modulation $0 - \pi$, dé là quantité $\Delta\omega.t$ considérée comme un glissement permanent (rampe continue dont la pente est donnée par la valeur de $\Delta\omega$ ), et de la quantité constante $\phi_o$.

Le diagramme 4c représente la succession dans le temps des tops de l'horloge 33.

Le diagramme 4b montre l'évolution du signal de sortie du compteur-décompteur 32. Il apparaît que ce signal suit, au rythme d l'horloge 33, les variations de la phase représentée figure 4a.

Le dispositif de démodulation tel que décrit ce-dessus est notamment applicable à un système séquentiel de transmission d'information, dans lequel une pluralité de stations $S_1 .... S_n$ reçoivent un message d'une station précédente, le décodent et le renvoient à la station suivante. Dans ce cas, chaque station possède forcément un oscillateur local, réglé sur le canal alloué, mais non synchrone des autres stations. Selon l'invention, ce signal remplace l'oscillateur 1 et est suffisant pour décoder les signaux reçus, sans qu'il soit nécessaire d'utiliser un oscillateur du type VCO. Les différentes stations mentionnées ci-dessus sont par exemple celles d'un système MLS.

Le dispositif selon l'invention n'est, bien entendu, pas limité aux modes particuliers de réalisation décrits. C'est ainsi notamment que le dispositif de la figure 2 a été décrit dans le cadre d'une modulation biphase $o-\pi$, mais qu'il est utilisable pour la démodulation d'une modulation multiphase, sous réserve que la variation de phase due à la différence $\Delta\omega$ reste,comme il a été dit ci-dessus, suffisamment lente par rapport à celle qui est due à la modulation $\theta(t)$ afin que ces deux variations soient séparables.

## Revendications

1. Dispositif de démodulation de phase, recevant un signal (s(t) à démoduler et destiné à coopérer avec un oscillateur fournissant un premier signal ($S_1$), de fréquence ($\omega_1$) fixe et voisine de celle ($\omega_o$) du signal à démoduler (s(t)), caractérisé par le fait qu'il comporte :

   - un déphaseur numérique (21), recevant le premier signal ($S_1$) et fournissant un deuxième signal ($S_2$) ;
   - dos moyens (51) de comparaison de la phase du signal à démoduler (s(t)) avec celle du deuxième signal ($S_2$) ;
   - un détecteur de signe (31) recevant le signal ($S_{51}$) issu des moyens de comparaison et fournissant un signal à un compteur-décompteur (32) commandé par une horloge (33), ce dernier fournissant une valeur numérique incrémentée ou décrémentée d'une unité, selon la commande du détecteur de signe, au rythme de l'horloge, cette valeur assurant la commande du déphaseur numérique (21) ;
   - des moyens (4) de traitement assurant un filtrage, recevant ladite valeur et formant le signal de sortie du dispositif.

2. Application du dispositif selon la revendication 1 à un système d'atterrissage du type MLS.

3. Application selon la revendication 2, caractérisée par le fait que le premier signal est fourni par le système MLS.

## Claims

1. Phase demodulation device receiving a signal (s(t)) to be demodulated and intended to co-operate with an oscillator supplying a first signal ($S_1$), of fixed frequency ($\omega_1$) neighbouring that ($\omega_0$) of the signal to be demodulated (s(t)), characterised in that it includes:

   - a digital phase-shifter (21), receiving the first signal ($S_1$) and supplying a second signal ($S_2$);
   - means (51) of comparing the phase of the signal to be demodulated (s(t)) with that of the second signal ($S_2$);
   - a sign detector (31) receiving the signal ($S_{51}$) arising from the comparison means and supplying a signal to a forward/backward counter (32) controlled by a clock (33), the latter supplying a digital value incremented or decremented by one unit, under the control of the sign detector, in tempo with the clock, this value affording control of the digital phase-shifter (21);
- processing means (4) affording a filtering, receiving the said value and forming the output signal of the device.

2. Application of the device according to Claim 1 to a landing system of the MLS type.

3. Application according to Claim 2, characterised in that the first signal is supplied by the MLS system.

**Patentansprüche**

1. Schaltung zur Phasendemodulation, die ein zu demodulierendes Signal (s(t)) empfängt und mit einem Oszillator zusammenwirken soll, der ein erstes Signal ($S_1$) einer festen Frequenz ($\omega_1$) nahe der Frequenz ($\omega_0$) des zu demodulierenden Signals (s(t)) liefert, dadurch gekennzeichnet, daß sie aufweist
   - einen digitalen Phasenschieber (21), der das erste Signal ($S_1$) empfängt und ein zweites Signal ($S_2$) liefert,
   - Mittel (51) zum Vergleich der Phase des zu demodulierenden Signals (s(t)) mit der des zweiten Signals ($S_2$),
   - einen Vorzeichendetektor (31), der das Ausgangssignal ($S_{51}$) der Vergleichsmittel empfängt und ein Signal an einen Vorwärts-Rückwärtszähler(32) liefert, der von einem Takt (33) gesteuert wird und einen digitalen, um eine Einheit vergrößerten oder verkleinerten Wert in Taktrhythmus gemäß der Steuerung durch den Vorzeichendetektor liefert, wobei dieser Wert die Steuerung des digitalen Phasenschiebers (21) bewirkt,
   - Verarbeitungsmittel (4), die eine Filterung bewirken und diesen Wert empfangen sowie das Ausgangssignal der Vorrichtung bilden.

2. Anwendung der Schaltung nach Anspruch 1 auf ein Landesystem vom Typ MLS.

3. Anwendung nach Anspruch 2, dadurch gekennzeichnet, daß das erste Signal vom MLS-System geliefert wird.

# FIG.1

# FIG.2

# FIG.3

22°,5

S$_{51}$

A  S$^+$

O

B  S$^-$

$\Phi_0$

t

22

EP 0 328 617 B1

FIG.4a

FIG.4b

Sortie compteur/décompteur

FIG.4c

Horloge

EP 0 328 617 B1